# EUROPEAN PATENT SPECIFICATION

(11) **EP 2 308 173 B1**
(45) Date of publication and mention of the grant of the patent: **19.09.2012**
(21) Application number: 09765911.4
(22) Date of filing: 18.06.2009
(51) Int. Cl.: E05F 15/00, H03K 17/955

(54) **ANTI-TRAP PROTECTION SYSTEM FOR MOVING SYSTEM**
EINKLEMMSCHUTZSYSTEM FÜR EIN BEWEGLICHES SYSTEM
SYSTÈME DE PROTECTION ANTI-COINCEMENT POUR SYSTÈME MOBILE

(30) Priority: 18.06.2008 DE 102008028932
(43) Date of publication of application: 13.04.2011
(73) Proprietor: IDENT Technology AG, 82205 Gilching (DE)
(72) Inventor: SCHWAIGER, Hans, 81377 München (DE); KANDZIORA, Thomas, 86947 Schwabhausen (DE); FAßHAUER, Peter, 85579 Neubiberg (DE); KALTNER, Claus, 85232 Bergkirchen (DE)
(74) Representative: Grubert, Andreas
(86) International application number: PCT/EP2009/057643
(87) International publication number: WO 2009/153332

(56) References cited:
- EP-A1- 0 062 568
- WO-A1-2007/048639
- DE-A1- 19 836 056
- DE-A1-102005 003 488
- US-A1- 2002 154 039

## Description

### Field of the invention

The invention relates to an anti-trap protection system for a moving system, especially for a convertible top system for vehicles. The invention moreover relates to a moving system with at least one moving component, one further component and an anti-trap protection system according to the invention. Moreover the invention relates to a vehicle, especially an automobile with an electrically actuated convertible top system and with an anti-trap protection system according to the invention.

### State of the art

In electrically, hydraulically or power-operated moving components in a moving system, like for example in convertible top systems in vehicles, there is, during the closing process and / or during the opening process of the moving system or the moving components, basically the danger of body parts getting caught, by which in some cases persons can be injured seriously. In the course of a more and more diffused application of electrically, hydraulically or power-operated sliding roofs or convertible tops, an early and safe detection of an entrapment situation is increasingly important, since the motion sequence of such convertible top systems for automobiles is frequently automatized and not monitored by an operator.

For example convertible motor vehicles frequently present a movable convertible top, which can be moved for example by key actuation semiautomatically or automatically from an open into a closed position or vice versa. The closing proccss of the convertible top can be caused however also by a sensor, for example a rain sensor, fully automatically. The convertible top motion usually takes place by a hydraulic drive, which drives a convertible top mechanism, that comprises the single movable components of a convertible top system. Moreover also tailgates or trunk lids can be moved electrically, hydraulically or power-operated, i.e. be opened and/or closed.

Known sensor systems for detection of a potential entrapment situation do not offer a sufficient anti-trap protection. For example it is known to implement for example an electrical sliding roof with pressure sensors, which on closing by means of the pressure against these pressure sensors are to recognize an entrapment situation. The use of pressure sensors however presents the serious disadvantage that a pressure against soft objects, for example a child's hand, is often insufficient for recognizing an entrapment situation with sufficient precision. Not recognizing such an entrapment situation may cause injury.

Further known sensor systems use the load of the driving component, which drives the movable parts of a convertible top system, in order to detect an entrapment situation. Exceeding a determined load of the driving component can be evaluated by the system as pressure against the closing component. The measurement can be direct or indirect, for example an rpm measurement.

The mentioned known sensor systems for detecting entrapment situations in moving systems moreover present the disadvantage that the movable or the closing component must first get into contact with the object which is in the moving area of the moving system in order to allow a detection of an entrapment situation in the first place. Another disadvantage of this systems is that first a determined pressure against the object situated in the range of motion of the moving system must be exceeded in order to recognize the object at all. Accordingly soft objects are not recognized or not early enough. Especially in the known systems a mechanical run-on of the movable components after recognizing the entrapment situation can entail that for example a closing process is for the moment continued before it is interrupted.

Further known sensor systems are based on an optic detection of the object situated in a range of motion of a moving system. For example it is known to provide infra-red sensor systems in lifts, with which a person situated between the movable lift doors is to be recognized. Such systems have the disadvantage that only a defined area of the range of motion of the lift doors can be supervised. A prevention of an entrapment in a not supervised area, for example in the lower area of the lift door, is usually not possible. Moreover infra-red sensor systems present the disadvantage that they are used only for monitoring a delimited area, since an extensive monitoring, like for example over the total height of lift doors, is complex and expensive.

US 2002/0154039 A1 discloses a capacitive sensor with a flexible housing for use with an automotive vehicle having power sliding door. The housing has a first set of electrodes and a second set of electrode interdigitally spaced from each other and a ground electrode. The first electrodes are supplied with a voltage signal. The second electrodes generate an input signal to a detecting device. The ground electrode is adapted for decrease the capacitive coupling between the first and the second electrodes.

From WO 2007/048639 A1 a circuit for detecting the presence and/or approach of an object in relation to at least one electrode device is known. A sensor electrode assembly comprises a first electrode device forming part of a capacitor system, whose capacitance to a reference potential is dependent on the presence of objects in an observation area. The sensor electrode assembly further comprises an evaluation circuit, which is coupled to the electrode device.

### Object of the invention

The object of the present invention is to avoid the known disadvantages at least partially and to provide an anti-trap protection system which can also be used in case of small available clearance and which reliably and possibly early detects an intrusion into the range of motion of electrically, hydraulically or power-operated components of a moving system, especially of a convertible top system of a vehicle, and above also makes possible monitoring the whole range of motion.

### Solution according to the invention

According to the invention this task is solved with an anti-trap protection system for a moving system and a vehicle with a convertible top system and an anti-trap protection system according to the characteristics of the independent claims. Further benefits and advantageous embodiments of the invention result from the description, the drawing and the claims.

### Short description of the figures

In the drawing, embodiments are illustrated in a schematically simplified way and in the following description explained more in detail.

The figures show:
- Fig. 1: an first example of an anti-trap protection system (Loading method), which does not form part of the invention.
- Fig. 2: another example of an anti-trap protection system (Absorption method), which does not form part of the invention.
- Fig. 3: an embodiment of an anti-trap protection system according to the invention combining the anti-trap protection systems shown in Fig. 1 and Fig. 2 (Loading/Absorption method);
- Fig. 4: an advantageous embodiment of an electrode for the anti-trap protection system according to the invention; and
- Fig. 5: a top system with an anti-trap protection system according to the invention in a car in the top view and in the side view.

### Detailed description of the invention

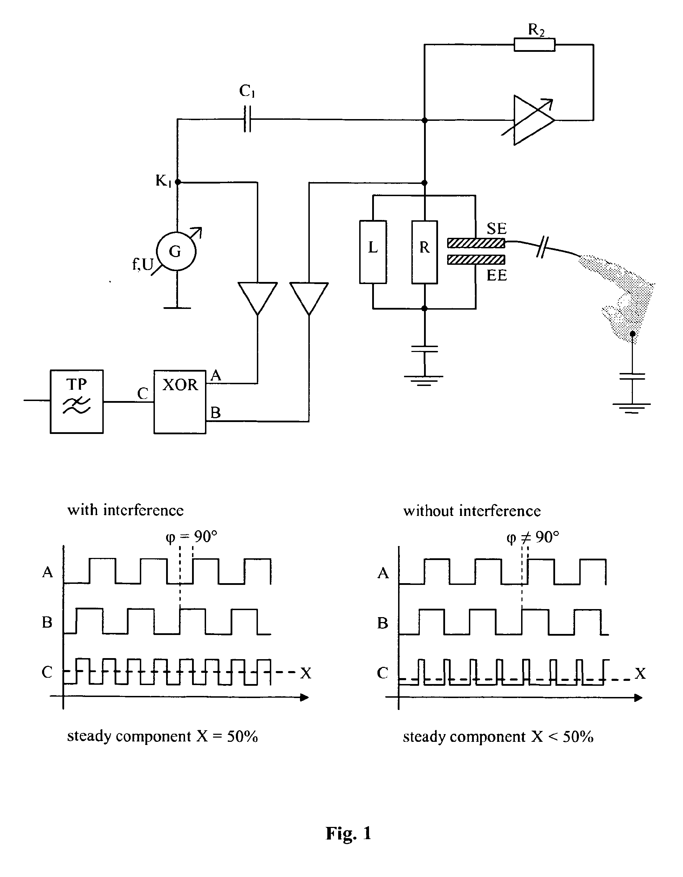

**Fig. 1** shows a circuit diagram of a first example of an anti-trap protection system which is useful for understanding the invention. The operation of the anti-trap protection system shown in Fig. 1 is indicated in the following as the so-called Loading method.

The anti-trap protection system has an oscillation circuit, which is formed advantageously as LC parallel resonance circuit. The LC parallel resonance circuit consists of a coil *L*, a capacitor *C* formed by the electrodes *SE* and *EE* and the ohmic resistance *R* occurring in a real LC parallel resonance circuit. The electrode *EE* or is coupled with mass.

The inductance *L* can be designed both as a passive and as an active inductance, for example as a Gyrator.

A signal generator *G*, which is preferably adjustable as for the generator frequency and the generator voltage, generates a signal with a cycle of typically 100...120 kHz. Higher or lower frequencies are possible according to the concrete application of the anti-trap protection system. By means of a second capacitor *C₁* the LC parallel resonance circuit is fed with the signal generated by the signal generator. At the same time also the electrode *SE* is fed with the signal of the signal generator (by means of the capacitor *C₁*). Preferably the generator frequency *F* of the generator *G* is tuned to the resonance frequency of the LC parallel resonance circuit, which makes possible a particularly good sensitivity of the anti-trap protection system as for an intrusion into a supervised area or a range of motion.

In operation at the electrode device, which comprises at least the electrodes *SE* and *EE,* or between the electrodes *SE* and *EE,* an electric field is generated, which corresponds to a determined capacity. If a part of the body approaches this electrode device, as in Fig. 1 schematically illustrated by a hand, the electric field betwcen the electrodes *SE* and *EE* changes and thus also the total capacity of the LC parallel resonance circuit.

A change of the capacity of the LC parallel resonance circuit leads to a phase shift of the signal at the LC parallel resonance circuit as to the signal provided by the signal generator *G*.

The signal provided by the signal generator *G* (at *K₁*) and the signal present at the LC parallel resonance circuit (at *K₂)* can (in combination) serve as indication for an approach of an object to the electrode device *(SE, EE).* Advantageously in this respect the phasing of both signals is exploited, in that the phase shift of the signal at the LC parallel resonance circuit is determined as to the signal provided by the signal generator *G*.

The signal provided by the signal generator *G* (in the following indicated by *S_{A}*) is tapped at the point *K₁*, the signal present at the LC parallel resonance circuit (in the following indicated by *S_{B})* is tapped at the point *K₂.* In normal operation, thus without an approach of an object to the electrode device *(SE, EE)* the phase shift of the signal *S*_{B} in the resonance point as to the signal *S_{A}* amounts to 90°.

Both signals *S_{A}* and *S_{B}* are fed to a comparator or two comparators in order to generate from the sinusoidal signals two square signals.

The square signals are fed to a gate, preferably a XOR gate or a gate -combination with XOR functionality. The signals at the entries A and B of the XOR gate (in the normal operation in the resonance point dephased by 90°) are illustrated in the chart "without intrusion" in Fig. 1 over time.

By means of the XOR function of the XOR gate, at its exit *C* a signal (in the following indicated by *S_{C}*) with a frequency equal to the double of the resonance frequency of the LC parallel resonance circuit is provided.

In this respect it is particularly important that the pulse width of the signal *S_{C}* depends on the phase shift or is directly proportional to the phase shift of the signal *S_{B}* compared to signal *S_{A}.* The signal *S_{C}* provided by the XOR gate can thus also serve as an indication for an approach of an object to the electrode device (*SE*, *EE*). In normal operation the pulse width of the signal *S_{C}* corresponds to half the pulse width of signal *S_{A}* or *S_{B}.* The signal *S_{C}* present at exit *C* is illustrated also in the chart "without intrusion" in Fig. 1 over time.

The phase shift unequal to 90°, resulting because of an approach of an object to the electrode device *(SE, EE*), of the signal *S_{B}* compared to signal *S_{A}* and the resulting (by means of XOR operation) signal *S_{C}* with a pulse width different from *S_{A}* or *S_{B}* are illustrated in the chart "with intrusion" in Fig. 1 over time.

The signal *S_{C}* present at the exit *C* of the XOR gate is fed to a low pass filter *TP.* The signal emitted by this low pass filter *TP* represents the steady component of the signal present at the low pass entry *S_{C}.* This steady component can thus also serve as indication for an approach of an object to the electrode device *(SE, EE).*

Depending on the concrete application field, for the normal operation, i.e. in the operation without intrusion in the range of motion, a predetermined value of the steady component is determined, which is characteristic for the normal operation.

In the example shown here according to Fig. 1 the steady component in normal operation amounts to almost 50%, particularly preferably exactly 50%.

A steady component of almost 50% serves thus as an indication for the fact, that no object has approached the electrode device *(SE, EE)* or is near the electrode device.

If an object approaches the electrode device *(SE, EE),* then, conditioned by the phase shift of the signal *S_{B}* as to the signal *S_{A},* the pulse width of the XORed signal S_{C} diminishes (cf. chart with intrusion in Fig. 1), which corresponds to a diminution of the steady component of the signal present at the this low pass filter exit. A steady component of less than 50% serves in this embodiment as indication for the fact that an object approaches the electrode device (*SE, EE*).

In the charts "without intrusion" and "with intrusion" the steady component is each time indicated by X. In another embodiment for the steady component an area (e.g. [45% ...50%]) can be defined, inside which a change or diminution of the steady component is not to be detected as an approach of an object to the electrode device. In this way for example the sensibility of the anti-trap protection system can be adjusted.

The signal present at the exit of the low pass filter *TP* can be fed to an evaluating device (not represented here). The evaluating device can then for example process the received signal, for example carry out a compensation of the signal. A compensation of the signal can be necessary for example if environmental technique influence or the ageing of the anti-trap protection system must be considered. Additionally the evaluating device can be coupled for example with a servomotor of a moving system, in order to stop in this way a closing component in the case in which an intrusion into the electrode device (*SE*, *EE)* was detected (i. e. when the steady component is smaller than a predestinated value) or to annul the closing process.

In the example shown here the signal generator *G* provided a sinusoidal wave signal. The anti-trap protection system according to the invention can be run however also with a signal generator which provides a square signal. In this case the comparator at the entrance *A* of the XOR gate can be dispensed with. In this respect additional EMC relevant conditions have to be observed.

The anti-trap protection system according to the example shown in Fig. 1 can be used as anti-trap protection system in vehicles.

In one form the system can be used for monitoring the range of motion of the movable components of a top system, for example a convertible roof. In doing so the electrode *SE* of the anti-trap protection system according to Fig. 1 is coupled with the movable part (or with the electric conductive parts) of the convertible top system. The movable part of the convertible top system thus constitutes the electrode *SE* of the anti-trap protection system.

The electrode *EE* is coupled with the vehicle frame, the chassis, or the vehicle body. Vehicle frame, chassis, and vehicle body each present a strong coupling to earth. Vehicle frame, chassis, or vehicle body form the electrode *EE* of the anti-trap protection system.

The movable part of the top system and the vehicle frame must not be electrically coupled with each other, that means, they must be mutually isolated. Especially the movable part of the convertible top system should not also be coupled with mass. In certain cases however a coupling against mass of the movable part is necessary or prescribed, for example in case of a tailgate on which several electric consumers can be arranged (e.g. taillights).

In case of an electrically lockable tailgate, the electrode SE can be formed by the tailgate, in order to detect in this way an intrusion into the range of motion of the closing tailgate using the anti-trap protection system according to the example.

In order to nevertheless allow the operation of the anti-trap protection system according to the example, it is proposed to decouple from mass the tailgate normally coupled with mass during the operation of the anti-trap protection system (thus during the closing process of the tailgate). For this purpose at those points at which the tailgate is connected with mass, a switchable insulator can be provided, which isolates only during the closing process. The tailgate can be decoupled electrically also using a shield electrode of the vehicle body.

On closing the top or the tailgate, because of changed distances the electric field between the top or the tailgate and the vehicle body changes, which corresponds to a change of the electric field between the electrode *SE* and the electrode *EE* or a change of the capacity of the condenser *C* formed by the electrodes *SE* and *EE.*

In order not to interpret such changes of the electric field conditioned by the adjusting process as an indication for an intrusion in the range of motion of the movable components, since on closing because of the capacitance changement also the steady component (or the phase shift) changes, arrangements are provided, which hide or compensate the changes conditioned by the adjusting process.

A compensation can happen for example by readjusting the signal generator *G*, so that it is always on the resonance frequency of the LC parallel resonance circuit. An intrusion into the electric field of the electrodes *SE* and *EE* causes a particularly strong capacitance changement over a short time (high speed of the capacitance change), which has as a consequence an abrupt reduction of the steady component. This effect is exploited for the readjustment of the signal generator *G.*

Moreover a compensation can take place on the basis of a trajectory, which for example indicates the steady component depending on the position of the top as to the vehicle body. This compensation can be done for example by the evaluating device, by comparing the current value present at the exit of the low pass *TP* with a desired value, which depends on the position of the top. A deviation from the desired value can be interpreted as indication for an intrusion into the range of motion of the movable component. For the deviation from the desired value a determined interval can be provided (e.g. ± 5%), within which a deviation is not to be interpreted as intrusion.

Additionally in the compensation also the moving speed of the top and / or the speed of the change of the steady component or the deviation from a desired value can be measured and included in the compensation process. In this way also variations of the trajectory which cannot be attributed to an intrusion in the range of motion can be adjusted. For example the present course of the steady component depending on the position of the top on a parking lot can be different from the present course in a parking garage. Equally the present course of the steady component can vary in case of a moving automobile.

Eventually a compensation can be done also by means of a quality factor control of the LC parallel resonance circuit. This can be done by a current input proportional to the oscillation circuit voltage. This can be realized by means of an adjustable amplifier *V* and a series resistance *R₂* situated between LC oscillating circuit and amplifier exit, by which a fed back system results.

Especially the anti-trap protection system shown in Fig. 1 is particularly insensitive to disturbances, since both the LC parallel resonance circuit because of its bandpass property and the low pass filter connected to the XOR exit filter out disturbers as far as possible.

If the moving system to be supervised has several moved components, all the moved components can be used as an electrode *SE*. At the same time it is sufficlient to provide only one electrode *EE*. For example the top and the tailgate of a vehicle each can form an electrode *SE*, and the vehicle body can form the electrode *EE*. In order to avoid reciprocal influences of the electrodes *SE* formed by the movable components, it is advantageous to charge the single movable components with a different generator frequency.

Alternatively also a switch can be provided in order to switch over between the single electrodes *SE* or to activate each time only one electrode *SE*. The switch can be realized by a multiplexer.

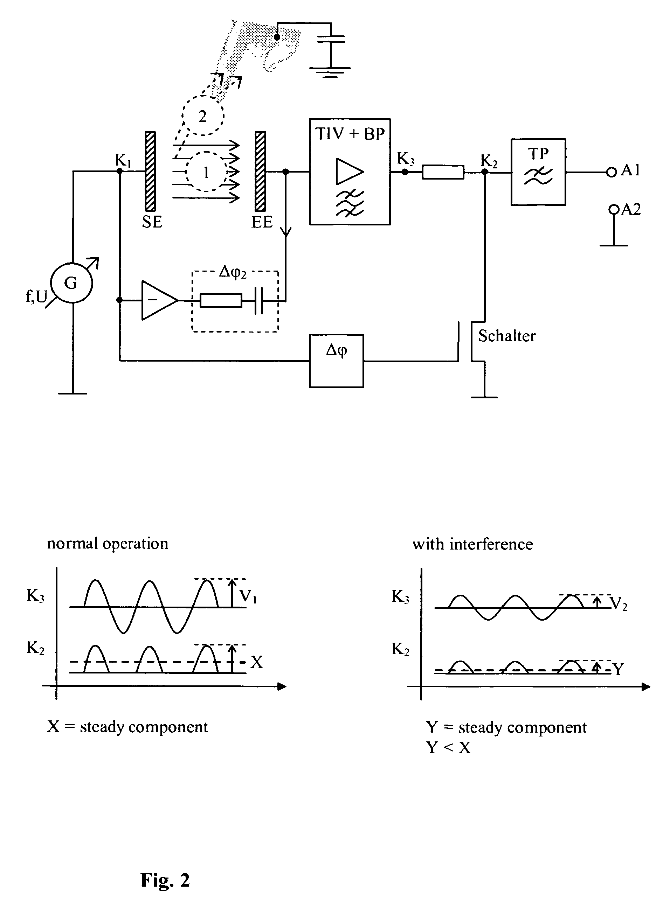

**Fig. 2** shows a circuit diagram of a second example of an anti-trap protection system which is useful for understanding the invention. The operation of the anti-trap protection system shown in Fig. 2 is indicated in the following as the so-called absorption method.

An electrode system formed by an electrode *SE* and an electrode *EE*, in which the electrodes *SE* and *EE* form a capacitor, is fed with a signal of a determined frequency. The electrode *SE* is coupled with the signal generator *G*. The signal is provided by the signal generator *G*, which preferably is adjustable in its frequency F and its generator voltage *U.*

In operation between the electrodes *SE* and *EE* an electric field 1 is generated, in which the capacitor formed by the electrodes *SE* and *EE* has a determined capacity.

The signal present at the exit of the electrode *EE* is fed to an amplifier with filter, preferably a transimpedance amplifier with bandpass filter (*TIV+ BP*).

The signal present at the exit of the transimpedance amplifier with bandpass filter is coupled with a signal tapped at the signal generator *G*, in which the tapped signal is fed first to a phase shifter Δϕ. The phase shifter Δϕ has the task of adapting the phase of the generator signal (at *K₁*) to the phase of the signal present at the exit of the transimpedance amplifier (at *K₂),* in order to compensate the phase shift of the generator signal caused by the electrodes *SE* and *EE* as well as by the transimpedance amplifier. The signal present at the exit of the transimpedance amplifier then has the same phase as that at the exit of the phase shifter Δϕ.

The signal present at the phase shifter exit has the task to switch the following switch.

This switch can be a transistor. This switch serves as synchronous demodulator, which is switched in the cycle of the signal generator *G* against mass, so that each time the signal present at the exit of the transimpedance amplifier is only fed to the following low pass filter *TP* when the switch is not switched against mass. Which part of the signal present at the exit of the transimpedance amplifier is fed to the low pass filter *TP,* depends on the phase shift of the signal provided by the phase shifter Δϕ compared to the signal at the point *K₂*. In a phase shift of ϕ= 0 thus only the positive half wave of the signal present at the exit of the transimpedance amplifier is fed to the following low pass filter *TP.*

By the synchronous demodulation at the same time also parasitic signals can be suppressed or compensated effectively.

The signal modulated in this way (signal at the point *K₂*) is then fed to a low pass filter *TP,* at the exit *(A₁, A₁)* of which then there is DC voltage. The signal at the exit *A₁, A₂* serves as an indication for a change of the electric field between the electrodes *SE* and *EE.*

The diagrams in Fig. 1 show the signals at *K₃, K₂* and at the exit *A1* each in normal operation (without intrusion into the electric field) as well as in case of intrusion into the electric field. The phase shifter Δϕ is set in such a way that the phase shift ϕ of the signal provided at the exit of the phase shifter Δϕ as to the signal at *K₃* preferably amounts to 0°.

In normal operation *K₃* has a sinusoidal signal with an amplitude *V₁.* By the modulation of the signal with the help of the switch, at the point *K₂* arises a sinusoidal signal, which comprises only the positive half wave of the original signal at *K₃*. With the low pass filter *TP* at the exit *A₁* a DC voltage with voltage *U* is provided. The steady component of the signal at exit *A₁* is indicated by X in the chart for the normal operation.

An intrusion into the electric field of the electrode device entails that a part of the electric field is absorbed and the amplitude V₁ of the original signal at point K*₃* diminishes down to the amplitude V*₂*. At the point K*₂* there is a sinusoidal signal with only positive half waves with the amplitude V*₂*. The DC voltage generated by the low pass *TP* has then a voltage U*₂*, which is smaller than the original voltage U in normal operation. A reduction of the voltage of the DC voltage present at exit A*₁* serves as indication for an intrusion into the electric field of the electrode device. The steady component of the signal present at exit A*₁* is indicated by *Y* in the chart for the intrusion.

The anti-trap protection system shown in Fig. 2 moreover has a countercurrent compensation. The signal provided by the signal generator *G* is coupled by means of a countercurrent compensation arrangement, which is formed by an adjustable inverting amplifier and a second phase shifter Δϕ₂, with the signal tapped at the electrode *EE*. The second phase shifter can be formed for example by a capacitor and a series resistance situated between capacitor and inverting amplifier. The second phase shifter Δϕ2 is necessary, since the signal tapped at the electrode *EE* does not necessarily comprise the same phase shift as to the generator signal as the signal at K₃.

The anti-trap protection system shown in Fig. 2 can be used as anti-trap protection system in vehicles.

In one form the anti-trap protection system can be used for monitoring the range of motion of the movable components of a convertible top system, for example a convertible roof. Here the electrode *SE* of the anti-trap protection system according to Fig. 2 is coupled with the movable part (or with the electrically conductive parts) of the convertible top system. The movable part of the convertible top system thus constitutes the electrode *SE* of the anti-trap protection system.

The electrode *EE* can be arranged at suitable places, for example in the upper area of the A-pillars or at the body component group connecting the A-pillars, the disposition being such that there is no electric coupling with the vehicle frame, the chassis or the vehicle body or against mass.

The movable part of the top system (= electrode *SE*) and the electrode *EE* thus jointly form an electrode device according to the anti-trap protection system shown in Fig. 2.

In operation on the electrode device or between the movable part of the convertible top system and the electrode *EE* an electric field forms, with which the range of motion of the movable part of the convertible top system can be supervised. An intrusion into this range of motion leads to a change of this electric field or the capacity of the condenser system formed by the electrode *EE* and the movable part of the convertible top system.

By the configuration of the circuit of the anti-trap protection system as shown in Fig. 2, at the exit A1 an equisignal is provided, which is indicative for an intrusion in this range of motion.

The output signal of the anti-trap protection system according to Fig. 2 can be fed to an evaluating device. The evaluating device can for example command the servomotor for the convertible top system, and in the event of intrusion (which corresponds to a reduction of the voltage at A*₁*) interrupt or annul the moving process.

In order to detect changes of the electric field conditioned by the adjusting process not as intrusion into the electric field of the electrode device, the anti-trap protection system can be formed in such a way that such changes can be compensated.

In a first variant the compensation can happen for example by readjusting the signal generator *G* as for its generator voltage *U*, so that the signal present at the electrode *EE* always has the same amplitude, independent from a change or not of the electric field of the electrode device.

Since the anti-trap protection system according to Fig. 2 has a high sensitivity, i. e. an intrusion into the electric field of the electrode device particularly strongly influences on the amplitude variation over time, an adjustment of the generator voltage can take place without adjusting and thus not detecting a change of the electric field on the electrode device caused by an intrusion.

Moreover a compensation can take place on the basis of a trajectory, the trajectory for example indicating the voltage at the exit A*1* depending on the position of the top as to the electrode EE. This compensation can be done for example by the evaluating device, by comparing the current value present at the exit A*1* with a desired value, which depends on the position of the top. A deviation from the desired value can be interpreted as indication for an intrusion into the range of motion of the movable component.

Alternatively or additionally in case of the compensation also the moving speed of the top and / or the speed of the change of the voltage at the exit A*1* or the deviation from a desired value can be measured and included in the compensation process.

In this way also variations of the trajectory which cannot be attributed to an intrusion in the range of motion can be adjusted.

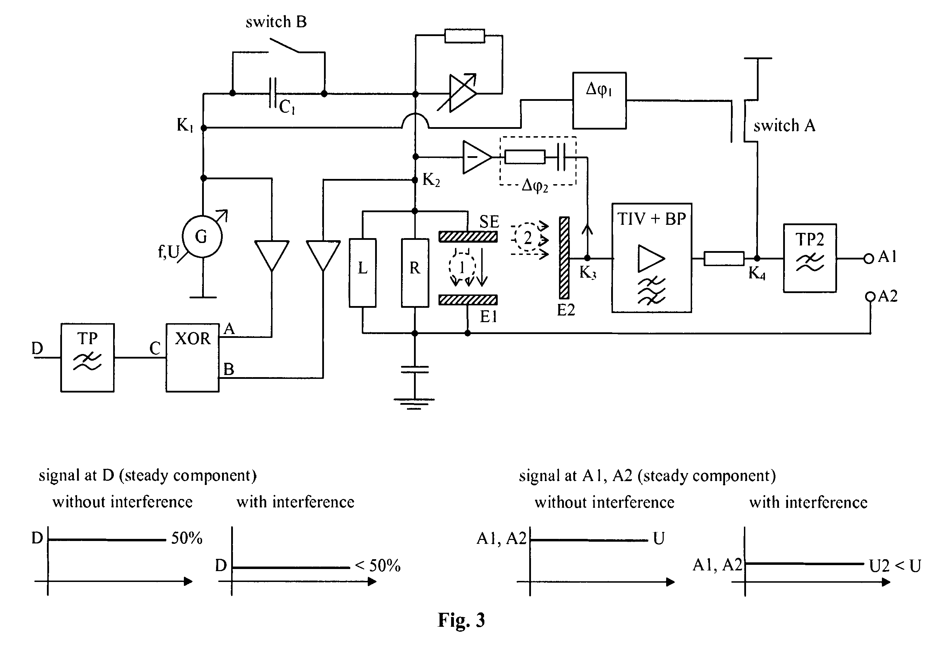

Special embodiments of the electrode(s) *EE* are described below in connection with the embodiment of an anti-trap protection system shown in Fig. 3.

Several electrodes *SE* can be provided. This can be reached for example by segmenting an electrode *SE.* Single electrodes of the several electrodes can be activated by a switch (e.g. a multiplexer) individually.

**Fig. 3** shows a circuit diagram of an embodiment of an anti-trap protection system according to the invention. The operation of the anti-trap protection system shown in Fig. 3 is indicated in the following as the so-called loading/absorption method.

Substantially the loading/absorption method is based on a combination of the loading method (cf. Fig. 1) with the absorption method (cf. Fig. 2). The special advantage of the combination of both these methods consists in the fact that two different methods based on the same principle are used for monitoring the range of motion, which guarantees an even safer and more effective anti-trap protection. The structure of the anti-trap protection system shown in the circuit diagram in Fig. 3 substantially corresponds to the structure (or the combination) of the anti-trap protection systems shown in Fig. 1 and Fig. 2.

Both systems are operated by a common signal generator *G*, which is adjustable as for the generator frequency *F* and the generator voltage *U.* The signal provided by the signal generator *G* is fed to a phase shifter Δϕ₁ and serves for switching the following switch A. At the same time by means of a capacity the LC oscillating circuit is fed with the signal provided by the signal generator *G.*

The electrode device as for the Loading method is formed by the electrodes *SE* and E*1*. The electrode device as for the absorption method is formed by the electrodes *SE* and *E2*. The electrode *SE* serves at the same time as transmission electrode for the loading method and for the absorption method, which makes possible a particularly advantageous structure of the anti-trap protection system according to the invention.

In operation at both electrode devices or between the electrodes *SE* and *E1* and between the electrodes *SE* and *E2* an electric field I or an electric field 2 forms. The electrode arrangement, for example on a vehicle with a convertible top device, preferably is selected in such a way that in case of an intrusion in the range of motion of the convertible top device at least one of the two electric fields varies, in order to be able to detect the intrusion. It is particularly preferred that the electrode arrangement is selected in such a way that the electric fields of both electrode devices vary.

The signal present at the point K₂ is, as described above for Fig. 1, dephased by 90° as to the signal provided by the signal generator (at K₁). The signals tapped at K₁ and K₂ are fed to a XOR gate by means of each time a comparator, the result of which is fed to a following low pass filter *TP*. The signal provided by the low pass filter *TP*, which indicates the steady component of the signal fed to the low pass filter *TP*, serves as an indication for an intrusion into the electric field of the electrode device *SE*, *E1* (cf above, description for Fig. 1). Thus the phase shift between the signals tapped at K*₁* and K₂ or the resonance performance is exploited in order to detect an intrusion.

The signal dephased by 90° at K₂ is also used to generate the electric field between the electrodes *SE* and *E2*. Thus also the signal present at K*₃* is dephased by 90° as to the generator signal in the resonance point.

In order to allow the synchronous demodulation described above for Fig. 2, the signal tapped at K*₁* is dephased by 90° with the phase shifter Δϕ₁, so that the switch A in the cycle of the signal generator switches the signal present at K*₄* against mass. This will allow that, also in combination with the loading method, to the low pass filter *TP2* are fed only the positive half waves of the signal present at K*₃*.

At the exit of the low pass filter *TP2* thus a DC voltage is available, which serves as indication for an intrusion into the electrode device *SE*, *E2* (cf. above, description of Fig. 2). Thus the amplitude variation of the signal present at exit *A1* is exploited in order to detect an intrusion.

The signal present at K₄, conditioned by the transimpedance amplifier with bandpass-property *(TIV* + *BP),* can also have a phase shift of unequal 90° as to the generator signal. In this case the phase shifter Δϕ₁ is to be designed in such a way that the signal provided by the phase shifter Δϕ₁ is in phase with the signal present at K₄.

Additionally a switch B can be provided in order to bridge the capacity by which the signal generator is coupled with the electrode *SE,* in order to prevent in this way a breakdown of the voltage at the circuit arrangement for the absorption process. The switch B can be coupled for example with a microcontroller, in order to allow for example a cyclic switching of switch B or a switching of switch B if necessary.

Additionally a countercurrent compensation arrangement is provided, which is formed as described in Fig. 2.

Also in this particularly advantageous embodiment of the anti-trap protection system according to the invention it is necessary to compensate changes conditioned by the adjusting process of the electric fields at the electrode devices, which occur for example on closing a convertible top system of an automobile, so that such changes are not recognized by mistake as an intrusion into the range of motion of the convertible top system.

For this purpose the methods already described above for Fig. 1 and Fig. 2 can be used.

A change of the phase shift of the signal tapped at K*₂* as to the signal tapped at K*₁*, conditioned by the adjusting process, can take place for example by adjusting the generator frequency *F,* so that the latter is always on resonance frequency of the LC parallel resonance circuit. A change of the amplitude of the signal present at K*₃* conditioned by the adjusting process can take place for example by adjustment of the generator voltage *U*.

The further methods described above for Fig. 1 and Fig. 2 can be also used both alternatively or in combination with the adjustment of the signal generator. Especially the quality adjustment described in Fig. 1 can be also used.

The anti-trap protection system shown in Fig. 3 can be coupled with an evaluation unit, which, depending on the signals present at the exits *D* or *A1*, commands an adjusting device, for example for a convertible top system for vehicles. The evaluating device can consider additional parameters. Typically let us name here parameters which consider temperature conditioned variations of single components of the anti-trap protection system based on their temperature dependence. Variations resulting from this at the output signals of the anti-trap protection system can be compensated or corrected by the evaluating device.

The anti-trap protection system according to the invention according to the embodiment shown in Fig. 3 can be used as anti-trap protection system for vehicles.

In one form the system can be used for monitoring the range of motion of the movable components of a convertible top system, for example a convertible roof. Here the electrode *SE* of the anti-trap protection system according to Fig. 3 is electrically coupled with the movable part (or with the electrically conductive parts) of the convertible top system.

The electrode SE according to Fig. 3 is formed in such a way by the movable part of the convertible top system.

The electrode *E2* can be arranged at suitable places, for example in the upper area of the A-pillars or in the body component group connecting the A-pillars, the disposition being selected in such a way that there is no electric coupling with the vehicle frame, the chassis or the vehicle body or against mass. The movable part of the convertible top system (= electrode *SE*) and the electrode *E2* so jointly form the electrode device *SE - E2* according to the anti-trap protection system shown in Fig. 3, on which in operation the electric field 2 forms.

The electrode *E1* is electrically coupled with the vehicle frame, the chassis, or the vehicle body. Vehicle frame, chassis and vehicle body each have a good coupling to earth. Vehicle frame, chassis or vehicle body form the electrode *E1* of the anti-trap protection system. The movable part of the convertible top system (= electrode *SE)* and the chassis (= electrode *E1*) so jointly form the electrode device *SE - E1* according to the anti-trap protection system shown in Fig. 3, on which in operation the electric field 1 forms.

In order to guarantee a correct way of functioning of the anti-trap protection system, the movable part of the convertible top system (= electrode *SE*) and the vehicle frame (= electrode *E1*) must not be electrically coupled with each other, that means, they must be isolated from each other. A separation of the normally coupled parts can take place as described above for Fig. 1 e.g. with the help of a switchable insulator. In this way the movable part of the convertible top system can always be decoupled from mass when a closing or opening process of the top system takes place.

In order to allow a good detection of an intrusion into the range of motion by the absorption switching according to Fig. 3 and Fig. 2, the form of the electrode *E2* (or the electrode *EE* in Fig. 2) is particularly important. In this respect it is advantageous to design the electrode E2 in such a way that its active area is possibly small in relation to the object penetrating into the range of motion (for example a hand). The smaller the active area is, so much the better is the detection, since the changes of the electric field or of the capacity of the condenser formed by the electrodes *SE* and *E2* are greater.

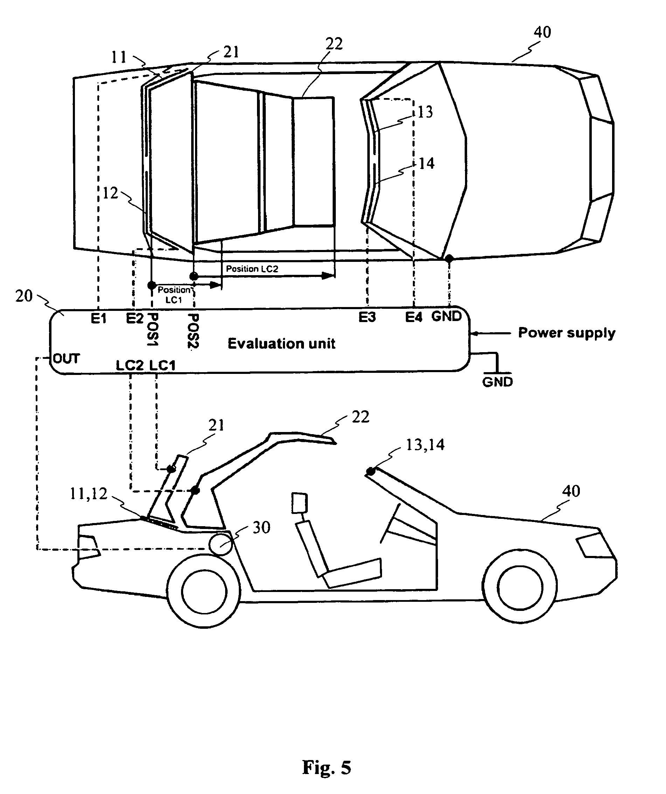

Therefore it can be necessary under particular conditions to provide several electrodes *E2* (so-called segmentation), in order to be able to survey a range of motion completely. This will ensure that with increasing size of the areas to be supervised the quality of the detection does not decrease. A special disposition of several electrodes *E2* is shown in Fig. 5.

There the electrodes 11, 12 or 13, 14 (= electrodes E2) are arranged symmetrically to the vehicle longitudinal axis. With a switch (for example a multiplexer) it is possible to activate always exactly one of the several electrodes *E2*. The switch is arranged preferably between the electrodes *E2* and the transimpedance amplifier *(TIV* + *BP).* At the exit *A1* then there is each time the signal for the active switched electrode *E2*.

The symmetric disposition of the electrodes E2 has several benefits:
1.) In addition to the intrusion into the range of motion also the direction from which the intrusion comes can be detected. This is possible thanks to the fact that the signal at A1, for that electrode at which the approach takes place, varies more than the signal at A1 or that of the other electrode(s). A (roughly) equal change of the output signals at A1 suggests that the approach or the intrusion into the range of motion takes place roughly in the centre.
2.) For the compensation process described above for compensation changes conditioned by the adjusting process, which carry out a compensation based on the position of the top as to the vehicle body, the determination of the position of the top can be dispensed with, since based on the symmetry of the electrodes the changes of the corresponding output signals proceed roughly equally, so that based on the difference of the changes between two electrodes independently of a compensation an intrusion in the range of motion can be detected based on the position. Additional sensors for determining the position of the top can so be dispensed with.

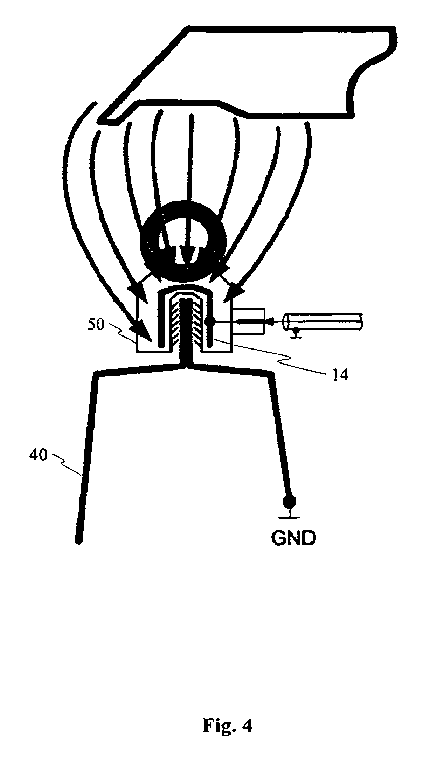

It is particularly advantageous to use means already present on a vehicle as electrodes *E2*. For example, as shown in Fig. 4, the retaining clamps that fix a sealing rubber at the body can be used.

Especially the method according to Fig. 3 can be run also using two electrodes SE, in which a first electrode SE1 is used for the loading method and another electrode *SE₂* for the absorption method.

**Fig. 4** shows the disposition of a retaining clamp in a sealing rubber 50 on the body 40, which can be used as electrode *E2* (reference sign 14). Many sealing rubbers present an integrated metallic retaining clamp for stably fixing the sealing rubber on the body. This retaining clamp can be used as electrode *E2*, by coupling the retaining clamp 14 accordingly with the circuit arrangement shown in Fig. 2 or in Fig. 3.

A retaining clamp arranged in a sealing rubber 50 can be segmented, so that for example the electrodes 13, 14 shown in Fig. 5 can be provided. Advantageously the segmentation takes place in such a way that the resulting electrode segments are arranged symmetrically to the vehicle longitudinal axis. Both segments then are accordingly coupled cach with the circuit arrangement shown in Fig. 2 or in Fig. 3, preferably by means of a multiplexer.

It is particularly advantageous to arrange the circuit arrangements shown in Fig. 2 or in Fig. 3 directly at the electrodes *E2* (thus on or in the sealing rubber), so that a signal processing can take place just off of the electrodes *E2.* Additional isolated or shielded lines for connecting the electrodes *E2* with the circuit arrangement thus are not necessary.

By using the retaining clamps present in the sealing rubber 50 as electrode(s) *E2*, the installation of additional electrodes can be dispensed with, so that a particularly space saving anti-trap protection is practicable.

Besides the disposition shown in Fig. 4 of an electrode *E2*, in which a retaining clamp provided as a standard feature in the sealing rubber 50 is used as an electrode, an electrode *E2* can be arranged also in another way at accordingly suitable places of the vehicle body 40.

For example a conductive layer can be arranged on the body, which is separated from the body by an insulating layer. For example as conductive layer a conductive varnish can be used and as insulating layer a non-conductive varnish. The use of conductive varnishes as electrode(s) *E2* makes possible a particularly flexible use of the anti-trap protection system according to the invention. A particular advantage of conductive varnishes consists in the fact that they maintain their geometry particularly well, as the performance of the anti-trap protection system can be influenced by a changing electrode geometry.

The use of wires arranged on the body (which must be isolated against the body) is also possible. In doing so it should be ensured that the geometry of the wires or the disposition of the wires cannot change unwantedly, for example by mechanical action on the wires.

**Fig. 5** shows an electrically movable top of a convertible vehicle with an anti-trap protection system according to the invention in the top view and in the side view. The top comprises a first movable top component 21 and another movable top component 22, the second movable top component 22 being for example a soft-top and the first movable top component 21 a protective flap for the stowage space, the movable top component 22 being stowed in the open state of the convertible top system.

On the fixed components of the convertible top system the electrodes 11, 12, 13 and 14 are arranged. The electrode arrangement can take place as described above. Other arrangements are also possible. The electrodes 13, 14 are arranged symmetrically to the vehicle longitudinal axis on the body component group connecting the A-pillars. The electrodes 11, 12 are arranged at or in the vehicle body 40 near the lower conclusion of the movable top component 21. The top components 21, 22 each take over the function of an electrode SE, as described in Fig. 1 to Fig. 3. On closing the convertible top system, the top component 22 and thus the electrode SE formed by the top component 22 approaches the two electrodes 13, 14 (in which the electrodes 13, 14 correspond to the electrode *EE* or *E2* from Fig. 2 or Fig. 3) and the vehicle body 40 (in which the vehicle body corresponds to the electrode *EE* or *E1* from Fig. 1 or Fig. 3).

The electrodes 13, 14 (= *E2* from Fig. 3), the electrode formed by the vehicle body *E1* and the electrode *SE* formed by the top component 22 are each accordingly connected with the circuit arrangement according to Fig. 3.

The exits of the circuit arrangement are fed to an evaluating device 20. The evaluating device 20 presents an exit *OUT,* which can be connected for its part with an adjusting device 30 for the drive of the top component 22. The evaluating device 20 presents two entries *POS1* and *POS2* with the current position of the two top components 21 and 22 during the locking process.

The electrodes 11, 12 as well as the top component 21 are also accordingly connected with the circuit arrangement according to Fig. 3. The entries of the evaluating device, to which the corresponding exits of the circuit arrangement for the electrodes 11 to 14 are connected, are indicated with the reference signs *E1* to *E4.* The exits, to which the electrodes *SE* (or 21 and 22) are connected, are indicated with the reference signs LC1 and LC2. The vehicle body, which constitutes the electrode *E1*, is coupled with mass over the entry GND.

Alternatively the evaluating device 20 can also present the corresponding circuit arrangements, so that the corresponding electrodes can be connected directly on the respective entries *E1* to *E4,* LC1 and LC2.

The evaluating device 20 can, as indicated in Fig. 5, consist of an integrated component.

During the locking process of the convertible top system the electric field between the single electrode devices varies. For example the electric field between the electrode 22 formed by the top component (= *SE)* and the electrode 13 (= *E2*) varies. A the same time also the electric field between the electrode 22 formed by the top component (= *SE)* and the electrode 40 formed by the body (= *E1*) varies. These variations have a determined characteristic for the top process. These variations conditioned by the adjusting process can be compensated if necessary as described above.

An intrusion into the range of motion of the top component 22 then leads to a change of the electric field of the single electrode device, which do not fit the characteristic of the top process and / or which no longer can be compensated by a compensation. This performance can be interpreted then as intrusion into the range of motion. How the detection or the survey takes place exactly, has been described above for the figures 1 to 3.

When recognizing an intrusion, the evaluating device 20 at its exit *OUT* of the adjusting device 30 makes a signal available, by which the break-off of the top process is signalled.

In the closed or in the open state of the convertible top system the total anti-trap protection system can be deactivated. Malfunctions in the open or closed state of the convertible top system thus can be prevented efficiently, since for the rest also in the open or in the closed state an electric field is in contact with the respective electrode devices. Alternatively the method according to the invention can be used however specifically also as vandalism or intrusion protection. In the closed state of a top for example an approach to the top can be recognized. In the open state a grabbing from the outside into the interior of the car can be recognized. In either instance for example an alarm can be triggered. Preferably the vandalism or intrusion protection is activable or deactivatable.

The anti-trap protection system according to the invention can be employed also in other areas, like for example in electrically closable doors (elevators, doors in trains) or other systems where there is the danger of entrapment of e.g. human limbs.

## Claims

1. Anti-trap protection system for a moving system, comprising
- at least one capacitor system, comprising
- a first electrode device with a first and a second electrode (E1);
- a second electrode device with a third and a fourth electrode (E2);
- a LC oscillating circuit (L, SE, E1) formed by the first electrode device and an inductance;
- a signal generator (G) for charging the first electrode device and the second electrode device with an adjustable frequency and amplitude;
- a capacitor (C1) for coupling the signal generator (G) with the first electrode device and the second electrode device; and
- an amplifier;
whereby
- the signal provided by the signal generator (G) and the signal present at the LC oscillating circuit form a first indication for an approach of an object to the electric field of the first electrode device, and
- the signal provided by the signal generator (G) and the signal tapped at the fourth electrode (E2) form a second indication for an approach of an object to the electric field of the second electrode device, whereby the signal tapped at the fourth electrode is fed to the amplifier, whereby the signal provided by the signal generator by means of a first phase shifter and a switch is used for the detection of the signal present at the exit of the amplifier, and whereby the steady component of the detected signal constitutes the second indication.

2. Anti-trap protection system according to claim 1, whereby the third electrode of the second electrode device is formed by the first electrode of the first electrode device.

3. Anti-trap protection system according to claim 1 or 2, further comprising a XOR gate for connecting the signal provided by the signal generator with the signal present at the LC oscillating circuit, whereby the signal provided by the signal generator and the signal present at the LC oscillating circuit by means of a comparator are fed to the XOR gate for producing a square signal, and whereby the steady component of the signal present at the XOR gate exit, which is smaller than a predetermined value, constitutes the first indication.

4. Anti-trap protection system according to claim 3, whereby the signal present at the XOR gate exit is fed to a low pass filter (TP) and whereby the steady component of the signal emitted by the low pass filter, which is smaller than a predetermined value, constitutes the first indication.

5. Anti-trap protection system according to one of the claims 1 to 4, whereby the amplifier is a transimpedance amplifier, preferably with bandpass feature.

6. Anti-trap protection system according to one of the claims 1 to 5, whereby the detected signal is fed to a low pass filter (TP2) and whereby the steady component of the signal present at the exit of the low pass filter, which is smaller than a predetermined value, constitutes the second indication.

7. Anti-trap protection system according to one of the claims 1 to 6, whereby the signal generator is adjustable as for the generator frequency and / or the generator voltage, whereby the anti-trap protection system can be coupled with an evaluating device and whereby the inductance is formed as a passive inductance or active inductance, preferably as a Gyrator.

8. Anti-trap protection system according to one of the claims 1 to 7, whereby this is formed in such a way that an intrusion into the range of motion of the moving system causes a variation of the first indication or the second indication.

9. Anti-trap protection system according to one of the claims 1 to 8, whereby a switch (B) for coupling the signal generator with the first or third electrode is provided.

10. Anti-trap protection system according to one of the claims 1 to 9, whereby the quality factor of the LC oscillating circuit is adjustable by a current input proportional to the oscillation circuit voltage.

11. Anti-trap protection system according to one of the claims 1 to 10, whereby the signal provided by the signal generator by means of a countercurrent compensation arrangement is coupled with the signal tapped at the fourth electrode, whereby the countercurrent compensation arrangement comprises an inverting amplifier and a second phase shifter coupled with it.

12. Vehicle, especially an automobile, with an electrically actuated convertible top system and with an anti-trap protection system according to one of the claims 1 to 11, whereby the convertible top system comprises at least one moved component and whereby the anti-trap protection system is formed in such a way that in the event of intrusion into the range of motion of the convertible top system the closing process or the opening process of the convertible top system can be interrupted, stopped or reversed.

13. Vehicle according to claim 12, whereby the first or third electrode of the anti-trap protection system is formed by the moved component of the convertible top system, whereby the second electrode is formed by the vehicle body or chassis and whereby the fourth electrode is formed by at least one electrode arranged isolated on the vehicle in the outer area of the range of motion of the convertible top system.

14. Vehicle according to claim 13, whereby the at least one electrode arranged isolated on the vehicle is arranged symmetrically to the longitudinal axis of the vehicle.

15. Vehicle according to one of the claims 12 to 14, whereby the anti-trap protection system in the closed and / or in the open state of the convertible top system is de-activable, and / or whereby the convertible top system is connected to the vehicle body by means of a preferably switchable insulator, and / or whereby the convertible top system, preferably using a shield electrode of the vehicle body, can be electrically decoupled.

## Patentansprüche

1. Antieinklemmschutzanordnung für eine sich bewegende Anordnung, die aufweist
- zumindest eine Kondensatoranordnung, die aufweist
- eine erste Elektrodenanordnung mit einer ersten und einer zweiten Elektrode (E1);
- eine zweite Elektrodenanordnung mit einer dritten und einer vierten Elektrode (E2);
- einen durch die erste Elektrodenanordnung und eine Induktivität gebildeten LC Schwingkreis (L, SE, E1);
- einen Signalgenerator (G) zum Laden der ersten Elektrodenanordnung und der zweiten Elektrodenanordnung mit einer einstellbaren Frequenz und Amplitude;
- einen Kondensator (C1) zum Koppeln des Signalgenerators (G) mit der ersten Elektrodenanordnung und der zweiten Elektrodenanordnung; und
- einen Verstärker;
wobei
- das durch den Signalgenerator (G) bereitgestellte Signal und das an dem LC Schwingkreis vorliegende Signal einen ersten Hinweis für eine Annäherung eines Objekts an das elektrische Feld der ersten Elektrodenanordnung bilden, und
- das durch den Signalgenerator (G) bereitgestellte Signal und das an der vierten Elektrode (E2) abgegriffene Signal einen zweiten Hinweis für eine Annäherung eines Objekts an das elektrische Feld der zweiten Elektrodenanordnung bilden, wobei das an der vierten Elektrode abgegriffene Signal in den Verstärker eingespeist wird, wobei das durch den Signalgenerator bereitgestellte Signal mittels eines ersten Phasenschiebers und eines Schalters für die Detektion des an dem Ausgang des Verstärkers vorliegenden Signals verwendet wird, und wobei die stationäre Komponente des detektierten Signals den zweiten Hinweis darstellt.

2. Antieinklemmschutzanordnung gemäß Anspruch 1, wobei die dritte Elektrode der zweiten Elektrodenanordnung durch die erste Elektrode der ersten Elektrodenanordnung gebildet wird.

3. Antieinklemmschutzanordnung gemäß Anspruch 1 oder 2, die weiterhin ein XOR Gatter zum Verbinden des durch den Signalgenerator bereitgestellten Signals mit dem an dem LC Schwingkreis vorliegenden Signal aufweist, wobei das durch den Signalgenerator bereitgestellte Signal und das an dem LC Schwingkreis vorliegende Signal zum Erzeugen eines Rechtecksignals mittels eines Komparators in das XOR Gatter eingespeist werden, und wobei die stationäre Komponente des am Ausgang des XOR Gatters vorliegenden Signals, die kleiner ist als ein vorgegebener Wert, den ersten Hinweis bildet.

4. Antieinklemmschutzanordnung gemäß Anspruch 3, wobei das am Ausgang des XOR Gatters vorliegende Signal in ein Tiefpassfilter (TP) eingespeist wird und wobei die stationäre Komponente des durch den Tiefpassfilter ausgegebenen Signals, die kleiner ist als ein vorgegebener Wert, den ersten Hinweis bildet.

5. Antieinklemmschutzanordnung gemäß einem der Ansprüche 1 bis 4, wobei der Verstärker ein Transimpedanzverstärker ist, vorzugsweise mit Bandpasseigenschaft.

6. Antieinklemmschutzanordnung gemäß einem der Ansprüche 1 bis 5, wobei das detektierte Signal in ein Tiefpassfilter (TP2) gespeist wird und wobei die stationäre Komponente des an dem Ausgang des Tiefpassfilters vorliegenden Signals, die kleiner ist als ein vorgegebener Wert, den zweiten Hinweis bildet.

7. Antieinklemmschutzanordnung gemäß einem der Ansprüche 1 bis 6, wobei der Signalgenerator hinsichtlich der Generatorfrequenz und / oder der Generatorspannung einstellbar ist, wobei die Antieinklemmschutzanordnung mit einer Auswerteanordnung gekoppelt werden kann und wobei die Induktivität als eine passive Induktivität oder aktive Induktivität ausgebildet ist, vorzugsweise als ein Gyrator.

8. Antieinklemmschutzanordnung gemäß einem der Ansprüche 1 bis 7, wobei diese auf eine solche Weise ausgebildet ist, dass ein Eindringen in den Bewegungsbereich der sich bewegenden Anordnung eine Veränderung des ersten Hinweises oder des zweiten Hinweises bewirkt.

9. Antieinklemmschutzanordnung gemäß einem der Ansprüche 1 bis 8, wobei ein Schalter (B) zum Koppeln des Signalgenerators mit der ersten oder dritten Elektrode bereitgestellt ist.

10. Antieinklemmschutzanordnung gemäß einem der Ansprüche 1 bis 9, wobei der Gütefaktor des LC Schwingkreises durch eine der Schwingkreisspannung proportionale Stromeingabe einstellbar ist.

11. Antieinklemmschutzanordnung gemäß einem der Ansprüche 1 bis 10, wobei das durch den Signalgenerator bereitgestellte Signal mittels einer Gegenstromkompensationsanordnung mit dem an der vierten Elektrode abgegriffenen Signal gekoppelt ist, wobei die Gegenstromkompensationsanordnung einen invertierenden Verstärker und einen zweiten damit gekoppelten Phasenschieber aufweist.

12. Fahrzeug, im Besonderen ein Automobil, mit einer elektrisch betätigten aufklappbaren Verdeckanordnung und mit einer Antieinklemmschutzanordnung gemäß einem der Ansprüche 1 bis 11, wobei die aufklappbare Verdeckanordnung zumindest eine bewegte Komponente aufweist und wobei die Antieinklemmschutzanordnung derart ausgebildet ist, dass in dem Fall des Eindringens in den Bewegungsbereich der aufklappbaren Verdeckanordnung der Schließvorgang oder der Öffnungsvorgang der aufklappbaren Verdeckanordnung unterbrochen, angehalten oder rückgängig gemacht werden kann.

13. Fahrzeug gemäß Anspruch 12, wobei die erste oder dritte Elektrode der Antieinklemmschutzanordnung durch die bewegte Komponente der aufklappbaren Verdeckanordnung gebildet wird, wobei die zweite Elektrode durch den Fahrzeugaufbau oder das Chassis gebildet wird und wobei die vierte Elektrode durch zumindest eine Elektrode gebildet wird, die isoliert an dem Fahrzeug in dem äußeren Bereich des Bewegungsbereiches der aufklappbaren Verdeckanordnung angeordnet ist.

14. Fahrzeug gemäß Anspruch 13, wobei die zumindest eine isoliert an dem Fahrzeug angeordnete Elektrode symmetrisch zu der Längsachse des Fahrzeugs angeordnet ist.

15. Fahrzeug gemäß einem der Ansprüche 12 bis 14, wobei die Antieinklemmschutzanordnung im geschlossenen und / oder im geöffneten Zustand der aufklappbaren Verdeckanordnung desaktivierbar ist, und / oder wobei die aufklappbare Verdeckanordnung mittels eines vorzugsweise schaltbaren Isolators mit dem Fahrzeugaufbau verbunden ist, und / oder wobei die aufklappbare Verdeckanordnung, vorzugsweise unter Verwendung einer Abschirmelektrode des Fahrzeugaufbaus, elektrisch entkoppelt werden kann.

## Revendications

1. Système de protection anti-pincement destiné à un système mobile, comprenant :
- au moins un système de condensateur qui comprend :
- un premier dispositif d'électrode doté d'une première électrode et d'une deuxième électrode (E1) ;
- un second dispositif d'électrode doté d'une troisième électrode et d'une quatrième électrode (E1) ;
- un circuit oscillant LC (L, SE, E1) formé par le premier dispositif d'électrode et une inductance ;
- un générateur de signal (G) destiné à charger le premier dispositif d'électrode et le second dispositif d'électrode avec une fréquence et une amplitude réglables ;
- un condensateur (C1) destiné à coupler le générateur de signal (G) avec le premier dispositif d'électrode et le second dispositif d'électrode ; et
- un amplificateur ;
grâce à quoi :
- le signal fourni par le générateur de signal (G) et le signal présent au niveau du circuit oscillant LC forment une première indication de l'approche d'un objet vers le champ électrique du premier dispositif d'électrode ; et
- le signal fourni par le générateur de signal (G) et le signal prélevé au niveau de la quatrième électrode (E2) forment une seconde indication de l'approche d'un objet vers le champ électrique du second dispositif d'électrode, grâce à quoi le signal prélevé au niveau de la quatrième électrode est fourni à l'amplificateur, grâce à quoi le signal fourni par le générateur de signal au moyen d'un premier déphaseur et d'un commutateur est utilisé pour la détection du signal présent au niveau de la sortie de l'amplificateur, et grâce à quoi la composante moyenne du signal détecté constitue la seconde indication.

2. Système de protection anti-pincement selon la revendication 1, dans lequel la troisième électrode du second dispositif d'électrode est formée par la première électrode du premier dispositif d'électrode.

3. Système de protection anti-pincement selon la revendication 1 ou 2, comprenant en outre une porte OU exclusif destinée à connecter le signal fourni par le générateur de signal et le signal présent au niveau du circuit oscillant LC, grâce à quoi le signal fourni par le générateur de signal et le signal présent au niveau du circuit oscillant LC au moyen d'un comparateur sont fournis à la porte OU exclusif de façon à produire un signal carré, et grâce à quoi la composante moyenne du signal présent au niveau de la sortie de la porte OU exclusif, qui est inférieure à une valeur prédéterminée, constitue la première indication.

4. Système de protection anti-pincement selon la revendication 3, dans lequel le signal présent au niveau de la sortie de la porte OU exclusif est fourni à un filtre passe-bas (TP) et dans lequel la composante moyenne du signal fourni par le filtre passe-bas, qui est inférieure à une valeur prédéterminée, constitue la première indication.

5. Système de protection anti-pincement selon l'une quelconque des revendications 1 à 4, dans lequel l'amplificateur est un amplificateur d'adaptation d'impédance, doté de préférence d'une caractéristique de bande passante.

6. Système de protection anti-pincement selon l'une quelconque des revendications 1 à 5, dans lequel le signal détecté est fourni à un filtre passe-bas (TP2) et dans lequel la composante moyenne du signal présent au niveau de la sortie du filtre passe-bas, qui est inférieure à une valeur prédéterminée, constitue la seconde indication.

7. Système de protection anti-pincement selon l'une quelconque des revendications 1 à 6, dans lequel le générateur de signal est réglable en ce qui concerne la fréquence du générateur et/ou la tension du générateur, grâce à quoi le système de protection anti-pincement peut être couplé à un dispositif d'évaluation et grâce à quoi l'inductance est formée sous la forme d'une inductance passive ou d'une inductance active, de préférence sous la forme d'un gyrateur.

8. Système de protection anti-pincement selon l'une quelconque des revendications 1 à 7, qui est conçu de telle façon qu'une intrusion dans la plage de mouvement du système mobile provoque une variation de la première indication ou de la seconde indication.

9. Système de protection anti-pincement selon l'une quelconque des revendications 1 à 8, dans lequel un commutateur (B) est fourni pour coupler le générateur de signal avec la première électrode ou la troisième électrode.

10. Système de protection anti-pincement selon l'une quelconque des revendications 1 à 9, dans lequel le facteur Q du circuit oscillant LC peut être réglé par une entrée de courant proportionnelle à la tension du circuit oscillant.

11. Système de protection anti-pincement selon l'une quelconque des revendications 1 à 10, dans lequel le signal fourni par le générateur de signal au moyen d'un agencement de compensation de contre-courant est couplé au signal prélevé au niveau de la quatrième électrode, grâce à quoi l'agencement de compensation de contre-courant comprend un amplificateur inverseur et un second déphaseur couplé à celui-ci.

12. Véhicule, en particulier une automobile, doté d'un système de toit décapotable actionné électriquement et d'un système de protection anti-pincement selon l'une quelconque des revendications 1 à 11, le système de toit décapotable comprenant au moins un composant mobile et le système de protection anti-pincement étant conçu de telle sorte que, dans le cas d'une intrusion dans la plage de mouvement du système de toit décapotable, le processus de fermeture ou le processus d'ouverture du système de toit décapotable puisse être interrompu, arrêté ou inversé.

13. Véhicule selon la revendication 12, dans lequel la première électrode ou la troisième électrode du système de protection anti-pincement est formée par le composant mobile du système de toit décapotable, dans lequel la deuxième électrode est formée par la caisse ou le châssis de véhicule, et dans lequel la quatrième électrode est formée par au moins une électrode agencée de façon isolée sur le véhicule dans la zone extérieure de la plage de mouvement du système de toit décapotable.

14. Véhicule selon la revendication 13, dans lequel la au moins une électrode agencée de façon isolée sur le véhicule est agencée symétriquement par rapport à l'axe longitudinal du véhicule.

15. Véhicule selon l'une quelconque des revendications 12 à 14, dans lequel le système de protection anti-pincement dans l'état fermé et/ou dans l'état ouvert du système de toit décapotable peut être désactivé, et/ou dans lequel le système de toit décapotable est connecté à la caisse du véhicule au moyen d'un isolant pouvant de préférence être commuté, et/ou dans lequel le système de toit décapotable peut être découplé électriquement, en utilisant de préférence une électrode de blindage de la caisse du véhicule.
